# EUROPEAN PATENT SPECIFICATION

(11) **EP 3 111 486 B1**
(45) Date of publication and mention of the grant of the patent: **01.05.2024**
(21) Application number: 15714934.5
(22) Date of filing: 26.02.2015
(51) Int. Cl.: H01L 31/074, H01L 31/18, H01L 31/0224, H01L 31/0236, C23C 16/02, C23C 16/40, C23C 16/455, C30B 7/00, C30B 29/16, C30B 29/60

(54) **PHOTOVOLTAIC CELL STRUCTURE AND METHOD OF MANUFACTURING A PHOTOVOLTAIC CELL**
FOTOVOLTAISCHE ZELLENSTRUKTUR UND VERFAHREN ZUR HERSTELLUNG EINER FOTOVOLTAISCHEN ZELLE
STRUCTURE DE CELLULE PHOTOVOLTAÏQUE ET PROCÉDÉ DE FABRICATION D'UNE CELLULE PHOTOVOLTAÏQUE

(30) Priority: 27.02.2014 PL 40733614
(43) Date of publication of application: 04.01.2017
(73) Proprietor: Instytut Fizyki Pan, 02-668 Warszawa (PL)
(72) Inventor: GIERALTOWSKA, Sylwia, PL-03-984 Warszawa (PL); GODLEWSKI, Marek, PL-03-543 Warszawa (PL); LUKA, Grzegorz, PL-35-036 Rzeszów (PL); PIETRUSZKA, Rafal, PL-27-612 Wilczyce (PL); WACHNICKI, Lukasz, PL-01-947 Warszawa (PL); WITKOWSKI, Bartlomiej, PL-03-138 Warszawa (PL)
(74) Representative: Witek, Rafal
(86) International application number: PCT/IB2015/051425
(87) International publication number: WO 2015/128825

(56) References cited:
- RAFAL PIETRUSZKA ET AL: "Photovoltaic properties of ZnO nanorods/p-type Si heterojunction structures", BEILSTEIN JOURNAL OF NANOTECHNOLOGY, vol. 5, 14 February 2014 (2014-02-14), pages 173-179, XP055198989, DOI: 10.3762/bjnano.5.17
- XIAO-MEI ZHANG ET AL: "n-ZnO/p-Si 3D heterojunction solar cells in Si holey arrays", NANOSCALE, vol. 4, no. 3, 9 December 2011 (2011-12-09), pages 737-741, XP055198996, ISSN: 2040-3364, DOI: 10.1039/C2NR11752E
- GRZEGORZ LUKA ET AL: "Transparent and conductive undoped zinc oxide thin films grown by atomic layer deposition", PHYSICA STATUS SOLIDI (A), vol. 207, no. 7, 31 May 2010 (2010-05-31), pages 1568-1571, XP055199003, ISSN: 1862-6300, DOI: 10.1002/pssa.200983709
- LUKA G ET AL: "Aluminum-doped zinc oxide films grown by atomic layer deposition for transparent electrode applications", JOURNAL OF MATERIALS SCIENCE: MATERIALS IN ELECTRONICS, KLUWER ACADEMIC PUBLISHERS, BO, vol. 22, no. 12, 19 April 2011 (2011-04-19), pages 1810-1815, XP019971583, ISSN: 1573-482X, DOI: 10.1007/S10854-011-0367-0

## Description

This invention relates to a photovoltaic cell structure and method to produce the same. Such structures can be used as electric power sources since they generate voltage when subjected to light.

There are descriptions of various kinds of photovoltaic structures in scientific and patent literature. The best known ones comprise silicon PV photovoltaic cells, which constitute almost 90% of the photovoltaic market. Currently, PV panels are commercially available, containing crystalline, thin-film silicon cells. Although significant progress in PV cells/structures based both on monocrystalline and polycrystalline silicon has been observed, the manufacturing technology is still too expensive and in the majority of cases it is simply uneconomical. The remaining 10% of the photovoltaic market consists of photovoltaic cells based on thin-film materials like: cadmium telluride (CdTe), cadmium sulfide (CdS), Copper indium gallium selenide (CIGS) alloys and multifunction cells using A^{III}B^{IV} meterials. The drawback of thin-layer CdTe-CdS cells is their high price (especially the cost of tellurium of which there is also too little to satisfy the photovoltaic market needs) as well as their negative environmental impact due to the application of cadmium. Another aspect limiting the applicability of CdTe based technology are the problems connected with the performance of ohmic contacts both for CdTe of p-type and CdS n-type. This impediments make CdTe and CdS difficult materials for photovoltaics. In case of cells based on Copper indium gallium selenide (CIGS) alloy the problem is similar since it is CdS that is used the most often as the partner for p-type conductivity of CIGS. Cells containing multiple layers of various materials are also known, the so-called multifunction cells, produced by means of molecular beam epitaxy (MBE). Structures of such cells are generally built of three layers. The lower layer is the substrate layer of germanium (Ge), the middle layer is an InGaAs multilayer, and the upper layer is also a multilayer, InGaP. The efficiency of the triple-junction cells is in fact the highest (of the magnitude of 40% in laboratory conditions), but their manufacturing cost is very high which makes their mass production impossible. Furthermore, the method to obtain tunnel layers stable in time is very complex, and those high efficiencies are obtained only in focused light conditions under which excessive heating of those cells occurs. From publication by R.Pietruszka, G. Luka, B.S. Witkowski, K. Kopalko, E. Zielony, P. Bieganski, E. Placzek-Popko, M. Godlewski, "Electrical and photovoltaic properties of ZnO/Si heterostructures with ZnO films grown by atomic layer deposition", Thin Solid Films, doi: 10.1016/j.tsf.2013.10.110, a photovoltaic cell structure is known, produced by means of atomic layer deposition - ALD - technology. The structure is a triple-layer structure in the arrangement of: p-type semiconductor / n-type semiconductor / transparent electrode. The substrate in this structure is the p-type semiconductor being the first layer, the second layer is zinc oxide film (n-type), and the third layer is zinc oxide film with admixture of aluminum. The manufacturing cost of the structure is relatively low in comparison with the commercially manufactured structures, and the efficiency of the cell built of such structures reaches 6%.

The object of the invention is to develop a photovoltaic structure of increased efficiency and relatively cheap production method of such structure.

The first object of the invention is a photovoltaic structure according to claim 1.

The second object of the invention is the method of manufacturing the photovoltaic cell structure according to claim 3. nucleating layer can be a layer of gold, silver or nanoparticles of those metals deposited by means of cathode sputtering, or a ZnO layer or ZnO nanoparticles deposited from solution or obtained by zinc salt annealing (e.g. zinc acetate) deposited from solution or during at least 1 ALD cycle, where, as zinc precursor, diethylzinc, dimethylzinc or zinc chloride is used, and water, ozone or oxygen plasma as oxygen precursor. It is preferred when the oxygen precursor in the reaction mixture is water, and the zinc precursor is zinc acetate. Preferably, ZnO film is deposited in at least 10 ALD cycles with diethylzinc, dimethylzinc or zinc chloride as zinc precursor, and water, ozone or oxygen plasma as oxygen precursor. Further on, the active layer is covered with a transparent ZnO:Al electrode film, which the upper electric contact is made on. Preferably, the transparent ZnO electrode film with aluminum admixture is deposited in at least 100 ALD cycles with diethylzinc, dimethylzinc or zinc chloride as zinc precursor, and water, ozone or oxygen plasma as oxygen precursor, and trimethylaluminum as aluminum precursor.

The obtained structure generates electrical voltage when subjected to visible, infrared or near UV light spectrum. The technology of execution of photovoltaic structure according to this invention is cheap and simple, and the structure is a multiple use structure.

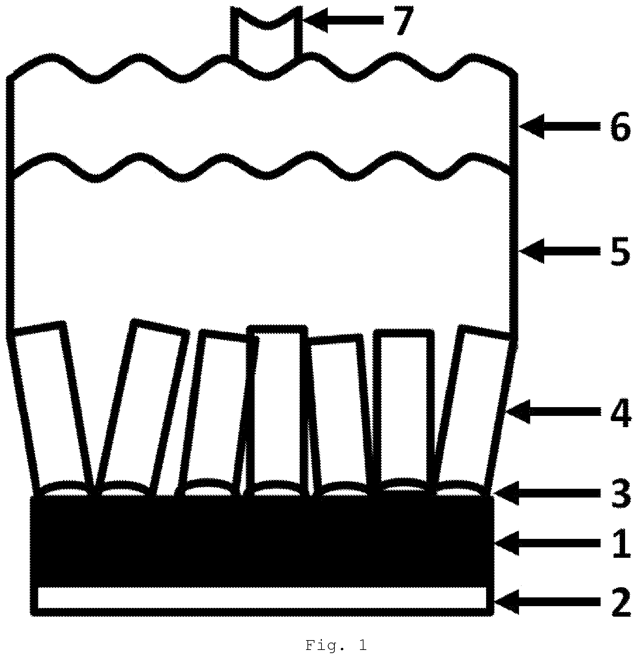

The invention will be explained in more detail with the Al/ZnO/ZnO_{NR}/Si/Al photovoltaic structure embodiment illustrated in fig. 1.

To carry out the example structure, commercially available p-type silicon substrate with electrical resistivity of 2.3 Ωcm and dimensions of 1.5 x 1.5 cm was used. First, the substrate was subjected to cleaning carried out in an ultrasonic cleaner. The substrate was cleaned in 3 steps of 30 seconds each, in isopropanol, acetone and deionized water consecutively. Upon the cleaned substrate 1, from the bottom, a film of aluminum 2, constituting the electric contact, was deposited with cathode sputtering. In the second step, the creation of the active ZnO layer in the form of ZnO nanorods 4 covered with thin film of ZnO 5 was commenced. For that purpose, first, silver nanoparticles constituting the nuclei 3 for hydrothermal growth of nanorods were deposited upon the upper surface of the substrate 1 also by cathode sputtering. Then, the substrate with the nuclei was placed in the reaction mixture containing dissolved zinc acetate brought to the pH value of 8. The mixture and the substrate were heated up to the temperature of 50°C and the growth of nanorods to the height of 650 nm was continued in the temperature for 2 minutes. After the growth completed, the substrate 1 with the crystallized nanorods 4 was rinsed in isopropanol to remove possible impurities, and deposition of ZnO layer 5 upon them started. For that purpose, the substrate was placed in an ALD reactor where it was annealed for 2 minutes in 200°C. After annealing, the reactor chamber was cooled down to 160°C, in which temperature the ZnO nanorods (and the substrate in part) were thoroughly covered with ZnO film ca. 200 nm thick in 1000 ALD cycles. Next, without removing the substrate with the deposited active layer from the ALD reactor, the transparent electrode 6 film was deposited. At the same temperature (160°) in 1700 ALD cycles, the active layer (nanorods 4 covered with ZnO layer 5) was covered with ZnO:Al film 300 nm thick, constituting the upper, transparent electrode 6. The electrode layer 6 was deposited using diethylzinc as zinc precursor, water as oxygen precursor, and trimethylaluminum as aluminum precursor. After depositing the electrode layer 6, the point ohmic contact to the ZnO:Al layer 7 made of aluminum was deposited by cathode sputtering process.

Covering the ZnO nanorods with the additional ZnO layer increased the area of the contact separating the carriers, which significantly increased the efficiency of the structure according to the invention. The obtained structure demonstrated the efficiency of ~12.5% (laboratory measurements made with sunlight simulator).

## Claims

1. A photovoltaic cell structure, comprising semiconductor p-type silicon substrate (1) with bottom electric contact (2), upon which an active ZnO film is present, with a transparent conductive layer (6) of ZnO:Al film upon it, with an electric contact (7),
**characterized in that**
active ZnO layer comprises ZnO nanostructured film (4) of 650 nm thickness consisting of a plurality of ZnO nanorods deposited on nucleating layer (3), and is covered with ZnO film (5) 200 nm thick.

2. The structure according to claim 1, **characterized in that** the nucleating layer is a layer of gold, silver or ZnO, or nanoparticles of these materials.

3. A method of manufacturing a photovoltaic cell structure, wherein upon a p-type silicon substrate (1) with bottom electric contact (2) an active layer of ZnO is deposited, upon which a transparent conductive layer (6), made of transparent ZnO:Al, and electric contact (7) are deposited, wherein upon the p-type substrate (1), an active ZnO layer is created in the form of ZnO nanostructured film (4) of 650 nm height deposited on a nucleating layer (3), wherein the method comprises the steps of covering the substrate (1) with the nucleating layer (3), placing the substrate (1) with the nucleating layer (3) in a reaction mixture with pH of 6.5-12, containing a solvent, at least one oxygen precursor, and at least one zinc precursor, heated up to the temperature of 30-95°C and keeping in this temperature for at least 1 second, and after completion of this process, removing the impurities from the substrate (1) and crystallized ZnO nanostructured film (4) consisting of a plurality of nanorods by annealing for at least 1 second in a temperature of ≥ 100°C, and covering the active ZnO layer with the transparent conductive layer (6) of ZnO:Al film, and with an electric contact (7), wherein after crystallization of the ZnO nanostructured film (4) a ZnO film (5) 200 nm thick is deposited in an ALD process.

4. The method of claim 3, **characterized in that** the nucleating layer (3) is deposited on the substrate (1) by cathode sputtering of gold, silver or nanoparticles of those metals.

5. The method of claim 3, **characterized in that** the nucleating layer (3) is an ZnO layer or ZnO nanoparticles deposited on the substrate (1) from a solution or obtained by annealing zinc salt deposited from a solution or deposited in at least 1 ALD cycle, wherein the zinc precursor is diethylzinc, dimethylzinc or zinc chloride, and the oxygen precursor is water, ozone or oxygen plasma.

6. The method of claim 3, **characterized in that** the oxygen precursor in the reaction mixture is water, and the zinc precursor is zinc acetate.

7. The method of claim 3, **characterized in that** the ZnO film (5) is deposited in at least 10 ALD cycles, using diethylzinc, dimethylzinc or zinc chloride as zinc precursor, and water, ozone or oxygen plasma as oxygen precursor.

8. The method of claim 3, **characterized in that** transparent conductive layer (6) made of transparent ZnO:Al is deposited in at least 100 ALD cycles with diethylzinc, dimethylzinc or zinc chloride as zinc precursor, water, ozone or oxygen plasma as oxygen precursor, and trimethylaluminum as aluminum precursor.

## Patentansprüche

1. Photovoltaische Zellstruktur mit einem Halbleitersubstrat (1) aus p-Silizium mit einem unteren elektrischen Kontakt (2), auf dem sich ein aktiver ZnO-Film befindet, mit einer darauf befindlichen transparenten leitenden Schicht (6) aus ZnO:Al-Film, mit einem elektrischen Kontakt (7) **dadurch gekennzeichnet, dass** die aktive ZnO-Schicht einen nanostrukturierten ZnO-Film (4) mit einer Dicke von 650 nm umfasst, der aus einer Vielzahl von ZnO-Nanostäbchen besteht, die auf der Keimbildungsschicht (3) abgeschieden sind, und mit einem ZnO-Film (5) mit einer Dicke von 200 nm bedeckt ist.

2. Struktur nach Anspruch 1, **dadurch gekennzeichnet, dass** die Keimbildungsschicht eine Schicht aus Gold, Silber oder ZnO oder aus Nanopartikeln dieser Materialien ist.

3. Verfahren zur Herstellung einer photovoltaischen Zellstruktur, wobei auf einem p-Siliziumsubstrat (1) mit unterem elektrischem Kontakt (2) eine aktive Schicht aus ZnO abgeschieden wird, auf der eine transparente leitende Schicht (6) aus transparentem ZnO:Al und ein elektrischer Kontakt (7) abgeschieden werden, wobei auf dem p-Substrat (1) eine aktive ZnO-Schicht in Form eines nanostrukturierten ZnO-Films (4) mit einer Höhe von 650 nm erzeugt wird, der auf einer Keimbildungsschicht (3) abgeschieden wird, wobei das Verfahren die folgenden Schritte umfasst Bedecken des Substrats (1) mit der Keimbildungsschicht (3), Anordnen des Substrats (1) mit der Keimbildungsschicht (3) in einer Reaktionsmischung mit einem pH-Wert von 6,5 bis 12, welche ein Lösungsmittel, mindestens einen Sauerstoffvorläufer und mindestens einen Zinkvorläufer enthält, und Erhitzen auf eine Temperatur von 30 bis 95 °C und Halten auf dieser Temperatur für mindestens 1 Sekunde lang, und nach Beendigung dieses Prozesses Entfernung der Verunreinigungen vom Substrat (1) und kristallisierte ZnO-Nanostrukturschicht (4), die aus einer Vielzahl von Nanostäbchen besteht, durch Ausglühen für mindestens 1 Sekunde bei einer Temperatur von ≥ 100 °C, und Bedecken der aktiven ZnO-Schicht mit der transparenten leitenden Schicht (6) aus ZnO:Al-Film und mit einem elektrischen Kontakt (7), wobei nach der Kristallisation des nanostrukturierten ZnO-Films (4) ein 200 nm dicker ZnO-Film (5) in einem ALD-Prozess abgeschieden wird.

4. Verfahren nach Anspruch 3, **dadurch gekennzeichnet, dass** die Keimbildungsschicht (3) durch Kathodenzerstäubung von Gold, Silber oder Nanopartikeln dieser Metalle auf dem Substrat (1) abgeschieden wird.

5. Verfahren nach Anspruch 3, **dadurch gekennzeichnet, dass** die Keimbildungsschicht (3) eine ZnO-Schicht oder ZnO-Nanopartikel ist, die auf dem Substrat (1) aus einer Lösung abgeschieden oder durch Tempern von Zinksalz erhalten wird, das aus einer Lösung abgeschieden oder in mindestens einem ALD-Zyklus abgeschieden wurde, wobei der Zinkvorläufer Diethylzink, Dimethylzink oder Zinkchlorid ist und der Sauerstoffvorläufer Wasser, Ozon oder Sauerstoffplasma ist.

6. Verfahren nach Anspruch 3, **dadurch gekennzeichnet, dass** der Sauerstoffvorläufer in der Reaktionsmischung Wasser ist und der Zinkvorläufer Zinkacetat ist.

7. Verfahren nach Anspruch 3, **dadurch gekennzeichnet, dass** der ZnO-Film (5) in mindestens 10 ALD-Zyklen abgeschieden wird, wobei Diethylzink, Dimethylzink oder Zinkchlorid als Zinkvorläufer und Wasser, Ozon oder Sauerstoffplasma als Sauerstoffvorläufer verwendet werden.

8. Verfahren nach Anspruch 3, **dadurch gekennzeichnet, dass** eine transparente leitfähige Schicht (6) aus transparentem ZnO:Al in mindestens 100 ALD-Zyklen mit Diethylzink, Dimethylzink oder Zinkchlorid als Zinkvorläufer, Wasser, Ozon oder Sauerstoffplasma als Sauerstoffvorläufer und Trimethylaluminium als Aluminiumvorläufer abgeschieden wird.

## Revendications

1. Structure de cellule photovoltaïque comprenant un substrat (1) semi-conducteur en silicium de type p, ayant un contact électrique inférieur (2), sur lequel se trouve un film actif de ZnO superposé d'une couche conductrice transparente (6) en film de ZnO:Al, ayant un contact électrique (7), **caractérisée en ce que** la couche active de ZnO comprend un film (4) nanostructuré de ZnO d'une épaisseur de 650 nm, constitué d'une pluralité de nanotiges de ZnO déposées sur une couche de nucléation (3), et est recouverte d'un film (5) de ZnO d'une épaisseur de 200 nm.

2. Structure selon la revendication 1, **caractérisée en ce que** la couche de nucléation est une couche d'or, d'argent ou de ZnO ou de nanoparticules de ces matériaux.

3. Procédé de fabrication d'une structure de cellule photovoltaïque, dans lequel une couche active de ZnO est déposée sur un substrat (1) en silicium de type p, ayant un contact électrique inférieur (2), sur laquelle sont déposés une couche conductrice transparente (6), réalisée en ZnO:AI transparent, et un contact électrique (7), sur le substrat (1) de type p, une couche active de ZnO est créée sous la forme d'un film (4) nanostructuré de ZnO d'une hauteur de 650 nm déposé sur une couche de nucléation (3), le procédé comprenant les étapes consistant à recouvrir le substrat (1) avec la couche de nucléation (3), placer le substrat (1) avec la couche de nucléation (3) dans un mélange réactionnel ayant un pH de 6,5 à 12, comprenant un solvant, au moins un précurseur d'oxygène, et au moins un précurseur de zinc, chauffé à une température de 30 à 95 °C et maintenu à cette température pendant au moins 1 seconde, et après achèvement de ce processus, éliminer les impuretés du substrat (1) et du film (4) nanostructuré de ZnO cristallisé, constitué d'une pluralité de nanotiges, par recuit pendant au moins 1 seconde à une température ≥ 100 °C, et recouvrir la couche active de ZnO avec la couche conductrice transparente (6) en film de ZnO:AI et avec un contact électrique (7), dans lequel, après cristallisation du film (4) nanostructuré de ZnO, un film (5) de ZnO d'une épaisseur de 200 nm est déposé par un processus ALD.

4. Procédé selon la revendication 3, **caractérisé en ce que** la couche de nucléation (3) est déposée sur le substrat (1) par pulvérisation cathodique d'or, d'argent ou de nanoparticules de ces métaux.

5. Procédé selon la revendication 3, **caractérisé en ce que** la couche de nucléation (3) est une couche de ZnO ou de nanoparticules de ZnO déposée sur le substrat (1) à partir d'une solution ou obtenue par recuit d'un sel de zinc déposé à partir d'une solution ou déposé au cours d'au moins un cycle ALD, le précurseur de zinc étant le diéthylzinc, le diméthylzinc ou le chlorure de zinc, et le précurseur d'oxygène étant l'eau, l'ozone ou le plasma d'oxygène.

6. Procédé selon la revendication 3, **caractérisé en ce que** le précurseur d'oxygène dans le mélange réactionnel est l'eau, et le précurseur de zinc est l'acétate de zinc.

7. Procédé selon la revendication 3, **caractérisé en ce que** le film (5) de ZnO est déposé au cours d'au moins 10 cycles ALD, en utilisant du diéthylzinc, du diméthylzinc ou du chlorure de zinc comme précurseur de zinc, et de l'eau, de l'ozone ou du plasma d'oxygène comme précurseur d'oxygène.

8. Procédé selon la revendication 3, **caractérisé en ce que** la couche conductrice transparente (6) réalisée en ZnO:AI transparent est déposée au cours d'au moins 100 cycles ALD avec du diéthylzinc, du diméthylzinc ou du chlorure de zinc comme précurseur de zinc, de l'eau, de l'ozone ou un plasma d'oxygène comme précurseur d'oxygène, et du triméthylaluminium comme précurseur d'aluminium.
